# EUROPEAN PATENT APPLICATION

(11) **EP 2 290 724 A1**
(43) Date of publication of application: **02.03.2011**
(21) Application number: 09746693.2
(22) Date of filing: 12.05.2009
(51) Int. Cl.: H01L 51/42

(54) **PHOTOELECTRIC CONVERSION ELEMENT**

(30) Priority: 13.05.2008 JP 2008125649
(71) Applicant: Sumitomo Chemical Company, Limited, Tokyo 104-8260 (JP)
(72) Inventor: KATO, Takehito, Oyama-shi Tochigi 323-0811 (JP)
(74) Representative: Vossius & Partner
(86) International application number: PCT/JP2009/059109
(87) International publication number: WO 2009/139487

(57) **Abstract**

A photoelectric conversion element including an anode, a cathode, an active layer formed between the anode and the cathode, and a functional layer formed between the active layer and the cathode, wherein the functional layer is formed by application of a dispersion liquid containing titanium dioxide particles dispersed therein.

## Description

### Technical Field

The present invention relates to a photoelectric conversion element.

### Background Art

Recently, much attention is being paid to organic photoelectric conversion elements utilizing light energy (organic solar cells, light sensors, and the like), and an organic photoelectric conversion element including a functional layer having various functions between an active layer and an electrode is being intensively studied so as to improve various characteristics of the element. An organic photoelectric conversion element in which a functional layer and an active layer are formed on a cathode is being studied and there is known, as an example thereof, an organic solar cell including a cathode, a TiOₓ layer formed on the cathode by applying a 2-methoxyethanol solution containing titanium(IV) isopropoxide, and an active layer and an anode formed on the TiOₓ layer ("Technical Digest of the International PVSEC-17", 17th International Photovoltaic Science and Engineering Conference (PVSEC-17) Organizing Committee, published on December 3, 2007, 6P-P5-17, pp. 1046-1047).

### Disclosure of the Invention

However, the photoelectric conversion element does not necessarily have high photoelectric conversion efficiency.

An object of the present invention is to provide a photoelectric conversion element having high photoelectric conversion efficiency.

First, the present invention provides a photoelectric conversion element including an anode, a cathode, an active layer formed between the anode and the cathode, and a functional layer formed between the active layer and the cathode, wherein the functional layer is formed by application of a dispersion liquid containing titanium dioxide particles dispersed therein.

Second, the present invention provides the above photoelectric conversion element, wherein the titanium dioxide particles have a particle size of 10 µm or less.

Third, the present invention provides the above photoelectric conversion element, wherein the dispersion liquid has a pH of 1 to 7.

Fourth, the present invention provides the above photoelectric conversion element, wherein the titanium dioxide particles have an electrical conductance of 0.01 mS/cm or more.

Fifth, the present invention provides the above photoelectric conversion element, which includes an organic layer between the active layer and the anode.

Sixth, the present invention provides the above photoelectric conversion element, wherein the organic layer contains a polymer compound.

Seventh, the present invention provides the above photoelectric conversion element, wherein one surface of the functional layer is in contact with the active layer and the other surface of the functional layer is in contact with the cathode.

Eighth, the present invention provides the above photoelectric conversion element, wherein one surface of the organic layer is in contact with the active layer and the other surface of the organic layer is in contact with the anode.

Ninth, the present invention provides the above photoelectric conversion element, wherein the active layer contains a fullerene derivative and a polymer compound.

Tenth, the present invention provides a method for manufacturing a photoelectric conversion element, which includes the steps of applying a dispersion liquid containing titanium dioxide particles dispersed therein to a cathode to form a functional layer; forming an active layer on the functional layer; and forming an anode on the active layer.

### Mode for Carrying Out the Invention

The present invention will be described in detail below.

The functional layer included in the photoelectric conversion element of the present invention is formed by application of a dispersion liquid containing titanium dioxide particles dispersed therein. It is preferred that the dispersion liquid used to form a functional layer contains a solvent and titanium dioxide particles, and that the titanium dioxide particles are fine particles. The particle size of the titanium dioxide particles is preferably 10 µm or less, and more preferably 1 µm or less. From the viewpoint of enhancing photoelectric conversion efficiency of the photoelectric conversion element, the particle size is more preferably 100 nm or less, and particularly preferably 50 nm or less. From the viewpoint of enhancing dispersibility of the titanium dioxide particles in a solvent, the particle size is preferably 30 nm or less. The description "the particle size of the titanium dioxide particles is 10 µm or less" in the present invention means that the particle sizes of substantially all titanium dioxide particles contained in a dispersion liquid are 10 µm or less. The particle size of the titanium dioxide particles can be measured, for example, by X-ray diffraction (XRD).

Examples of the solvent contained in the dispersion liquid include water, alcohols, and the like, and examples of alcohols include methanol, ethanol, isopropanol, butanol, ethylene glycol, propylene glycol, butoxyethanol, methoxybutanol, and the like. The dispersion liquid used in the present invention may contain two or more of these solvents.

The amount of the solvent is usually from about 500 to 3, 000 parts by weight based on 100 parts by weight of the titanium dioxide particles.

In order to enhance dispersibility of the titanium dioxide particles in the solvent, it is preferred to add a dispersing agent to the dispersion liquid. Examples of the dispersing agent include organic acids such as acetic acid; and inorganic acids such as hydrochloric acid, nitric acid, and sulfuric acid. From the viewpoint of ease of handling of the dispersion liquid and prevention of corrosion of electrodes, acetic acid is preferred.

The amount of the acids (organic acids or inorganic acids) is usually from about 5 to 400 parts by weight based on 100 parts by weight of the titanium dioxide particles.

The pH of the dispersion liquid is preferably from 1 to 7, more preferably from 1 to 5. It is still more preferably from 1 to 3, from the viewpoint of enhancing dispersibility of the titanium dioxide particles in the solvent.

The electrical conductance of the titanium dioxide particles is preferably 0.01 mS/cm or more, and more preferably 1 mS/cm or more. The electrical conductance is preferably 10 mS/cm or more from the viewpoint of enhancing the photoelectric conversion efficiency. The titanium dioxide particles constituting the functional layer are particles having a crystal structure.

The functional layer included in the photoelectric conversion element of the present invention is formed by application of the above dispersion liquid containing titanium dioxide particles dispersed therein. Examples of the method of applying the dispersion liquid include application methods such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a dispenser printing method, a nozzle coating method, and a capillary coating method. Among these application methods, a spin coating method, a flexographic printing method, an ink jet printing method, and a dispenser printing method are preferred.

The functional layer preferably has a film thickness within a range from 1 nm to 100 pm, more preferably from 2 nm to 1,000 nm, still more preferably from 5 nm to 500 nm, and particularly preferably from 20 nm to 200 nm.

The functions of the above functional layer include a function of enhancing an injection efficiency of an electron into a cathode, a function of preventing injection of a positive hole from an active layer, a function of enhancing a transport ability of an electron, a function of reflecting incident light, a function of suppressing deterioration of an active layer, and the like.

Examples of materials of electrodes (anode, cathode) included in the photoelectric conversion element of the present invention include transparent or translucent electrode materials, and opaque electrode materials.

Examples of transparent or translucent electrode materials include an electrically conductive metal oxide film and a translucent metal thin film. Specifically, films made of electrically conductive materials (NESA, and the like) such as indium oxide, zinc oxide, tin oxide, and indium tin oxide (ITO) and indium zinc oxide as composites thereof, gold, platinum, silver, copper, and the like are used, and ITO, indium zinc oxide and tin oxide are preferred.

The opaque electrode materials are preferably materials containing metals. The opaque electrode materials may contain oxides of metals and halides of metals. However, on the' assumption that the weight of metals is 100, the total of the weight of oxides of metals and the weight of halides of metals is preferably 10 or less, and it is more preferred that the opaque electrode materials substantially consist only of metals. Examples of metals include lithium, beryllium, sodium, magnesium, aluminum, potassium, calcium, scandium, titanium, vanadium, chromium, manganese, iron, cobalt, nickel, copper, zinc, gallium, germanium, rubidium, strontium, yttrium, zirconium, niobium, molybdenum, ruthenium, rhodium, palladium, silver, cadmium, indium, tin, antimony, cesium, barium, lanthanum, hafnium, tantalum, tungsten, rhenium, osmium, iridium, platinum, gold, mercury, thallium, lead, bismuth, lanthanide, and the like. It is also possible to use, for example, an alloy of these metals, graphite or an intercalation compound of these metals with graphite. Among these metals, aluminum, magnesium, titanium, chromium, iron, nickel, copper, zinc, gallium, zirconium, molybdenum, silver, indium and tin are preferred. The method of preparing the cathode includes a vacuum vapor deposition method, a sputtering method, an ion plating method, a plating method, and the like. Alternatively, a metal electrode can be prepared by an application method using a metal ink, a metal paste, a low-melting metal, or the like.

In the photoelectric conversion element of the present invention, the cathode is preferably transparent or translucent.

It is preferred that the anode included in the photoelectric conversion element of the present invention contains a metal.

The photoelectric conversion element of the present invention is usually formed on a substrate. The substrate may be made of any material which forms an electrode and does not alter when layers containing organic materials are formed. Examples of the material for the substrate include glass, plastic, polymer films, silicon, and the like. In the case of an opaque substrate, an electrode opposite to the substrate (i.e. an electrode distal from the substrate) is preferably transparent or translucent.

Next, the actuating mechanism of the photoelectric conversion element will be explained. The light energy incident from a transparent or translucent electrode is absorbed by an electron-accepting compound and/or an electron-donating compound to generate an exciton consisting of an electron and a hole bound together. When the generated exciton moves and reaches a heterojunction interface where the electron-accepting compound and the electron-donating compound are present adjacently, the electron and the hole separate due to the difference of their HOMO energy and LUMO energy in the interface to generate charges (electron and hole) capable of moving separately. The generated charges can move to respective electrodes, thus making it possible to be taken outside as electric energy (current).

Therefore, the photoelectric conversion element usually contains an electron-accepting compound and an electron-donating compound. The active layer of the present invention contains an electron-accepting compound and/or an electron-donating compound. Concerning the ratio of the electron-accepting compound to the electron-donating compound, the amount of the electron-donating compound is preferably from 10,000 parts by weight to part by weight, more preferably from 1,000 parts by weight to 10 parts by weight, and still more preferably from 500 parts by weight to 1 part by weight based on 100 parts by weight of the electron-accepting compound.

Examples of the structure of the photoelectric conversion element include:
1. A photoelectric conversion element including an anode and a cathode; a first active layer containing an electron-accepting compound formed between the anode and the cathode; a second active layer containing an electron-donating compound formed adjacently to the first active layer; and a functional layer formed between the cathode and the first active layer adjacently to the cathode;
2. A photoelectric conversion element including an anode and a cathode; a first active layer containing an electron-accepting compound formed between the anode and the cathode; a second active layer containing an electron-donating compound formed adjacently to the first active layer; and a functional layer formed between the cathode and the second active layer adjacently to the cathode;
3. A photoelectric conversion element including an anode and a cathode; an active layer containing an electron-accepting compound and an electron-donating compound formed between the anode and the cathode; and a functional layer formed between the cathode and the active layer adjacently to the cathode;
4. A photoelectric conversion element including an anode and a cathode; an active layer containing an electron-accepting compound and an electron-donating compound formed between the anode and the cathode; an organic layer formed between the anode and the active layer adjacently to the anode; and a functional layer formed between the cathode and the active layer adjacently to the cathode;
5. A photoelectric conversion element including an anode and a cathode; an active layer containing an electron-accepting compound and an electron-donating compound formed between the anode and the cathode; and a functional layer formed between the cathode and the active layer adjacently to the cathode; wherein the electron-accepting compound is a fullerene derivative; and
6. A photoelectric conversion element including an anode and a cathode; an active layer containing an electron-accepting compound and an electron-donating compound formed between the anode and the cathode; an organic layer formed between the anode and the active layer adjacently to the anode; and a functional layer formed between the cathode and the active layer adjacently to the cathode; wherein the electron-accepting compound is a fullerene derivative.

In the photoelectric conversion elements according to the above items 5 and 6, the amount of the fullerene derivative in the active layer containing the fullerene derivative and an electron-donating compound is preferably from 10 to 1,000 parts by weight, and more preferably 50 to 500 parts by weight, based on 100 parts by weight of the electron-donating compound.

The photoelectric conversion element is preferably the element according to the above items 3, 4, 5 or 6, and more preferably the element according to the above item 5 or 6 from the viewpoint that it contains many heterojunction interfaces.

The electron-accepting compound used suitably for the photoelectric conversion element is one in which the HOMO energy of the electron-accepting compound is higher than the HOMO energy of the electron-donating compound, and the LUMO energy of the electron-accepting compound is higher than the LUMO energy of the electron-donating compound.

The above electron-donating compound may be a low-molecular compound or a polymer compound. Examples of the low-molecular compound include phthalocyanine, metallophthalocyanine, porphyrin, metalloporphyrin, oligothiophene, tetracene, pentacene, rubrene, and the like. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, polyfluorene and derivatives thereof, and the like.

The electron-accepting compound may be a low-molecular compound or a polymer compound. Examples of the low-molecular compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as C₆₀ fullerene and derivatives thereof, phenanthrene derivatives such as 2,9-dimethyl-4,7-diphenyl-1,10-phenanthroline, and the like. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, polyfluorene and derivatives thereof, and the like. Among them, fullerenes and derivatives thereof are preferred.

The fullerenes include C₆₀ fullerene, C₇₀ fullerene, carbon nanotube fullerene, and derivatives thereof. The following compounds are mentioned as examples of fullerene derivatives.

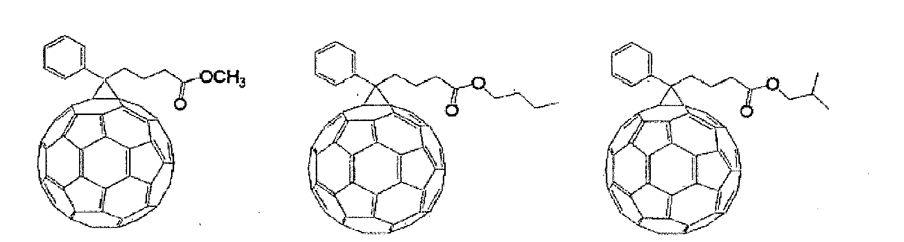

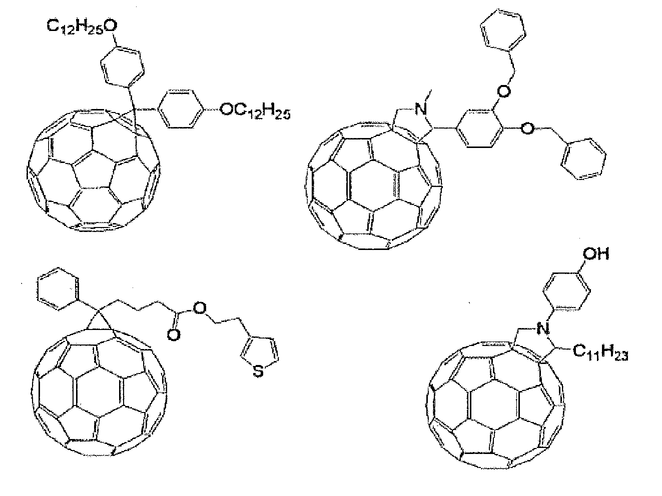

The active layer in the photoelectric conversion element of the present invention preferably contains a polymer compound, and may contain a single polymer compound, or two or more polymer compounds. It is also possible to use a mixture of an electron-donating compound and/or an electron-accepting compound in the above active layer in order to enhance a charge transport ability of the above active layer. In particular, it is preferable that a conjugated polymer compound and a fullerene derivative are contained in the active layer. For example, it is possible to use an organic thin film containing a conjugated polymer compound and a fullerene derivative as an active layer. Examples of the above conjugated polymer compound include polymer compounds which contain, as a repeating unit, one group or two or more groups selected from the group consisting of an unsubstituted or substituted fluorenediyl group, an unsubstituted or substituted benzofluorenediyl group, a dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, and an unsubstituted or substituted triphenylaminediyl group, the repeating unit being bound to another repeating unit directly or via a linking group.

If the above repeating unit is bound to another repeating unit via a linking group in the above conjugated polymer compound, examples of the linking group include phenylene, biphenylene, naphthalenediyl, anthracenediyl, and the like.

Preferable examples of the conjugated polymer compound include polymer compounds which contain one repeating unit or two or more repeating units selected from the group consisting of polymer compounds having a fluorenediyl group and a thiophenediyl group, the repeating unit being bound to another repeating unit directly or via a linking group.

The above organic thin film usually has a film thickness within a range from 1 nm to 100 µm, preferably from 2 nm to 1,000 nm, more preferably from 5 nm to 500 nm, and still more preferably from 20 nm to 200 nm.

The method for manufacturing an organic thin film used in the active layer includes, for example, a method for formation of a film from a composition containing a solvent, a conjugated polymer compound and a fullerene derivative. The same application method as that explained in the formation of the functional layer can be used for formation of a film.

When the photoelectric conversion element of the present invention includes an organic layer between an active layer and an anode, the organic layer is preferably made of a polymer compound, and more preferably made of a highly electrically conductive polymer compound.

The highly electrically conductive polymer compound usually has electrical conductivity within a range from 10 to 10,000 ohm·cm in view of resistivity.

By forming the organic layer consisting of a highly electrically conductive polymer compound adjacently to an anode and an active layer, it is possible to enhance not only tight adhesion between the anode and the active layer, but also hole (positive hole) -injection efficiency from the active layer to the electrode. Examples of the polymer compound include a polymer compound having a thiophenediyl group, a polymer compound having an anilinediyl group, a polymer compound having a pyrrolediyl group, a polymer compound having a fluorenediyl group, and the like.

The organic layer used in the present invention can be formed by application of a solution containing a polymer compound and a solvent. It is possible to use, as the application method, the same method as the method of forming a functional layer. The functions of the organic layer include a function of enhancing an injection efficiency of a positive hole into an anode, a function of preventing injection of electrons from an active layer, a function of enhancing a transport ability of a positive hole, a function of enhancing flatness upon vapor deposition of an anode, a function of protecting an active layer from erosion with a solvent when an anode is made by an application method, a function of reflecting light incident from a cathode, a function of suppressing deterioration of an active layer, and the like.

The photoelectric conversion element of the present invention may further include an inorganic layer.

The inorganic layer can be formed, for example, as an intermediate layer between a cathode and a functional layer, an intermediate layer between a functional layer and an active layer, an intermediate layer between an anode and an organic layer, or an intermediate layer between an organic layer and an active layer.

Examples of the material contained in the inorganic layer include metal oxides such as titanium oxide, tin oxide, zinc oxide, iron oxide, tungsten oxide, zirconium oxide, hafnium oxide, strontium oxide, indium oxide, cerium oxide, yttrium oxide, lanthanum oxide, vanadium oxide, niobium oxide, tantalum oxide, gallium oxide, nickel oxide, strontium titanate, bariumtitanate, potassium niobate, and sodium tantalate; metal halides such as silver iodide, silver bromide, copper iodide, and copper bromide; metal sulfides such as zinc sulfide, titanium sulfide, indium sulfide, bismuth sulfide, cadmium sulfide, zirconium sulfide, tantalum sulfide, molybdenum sulfide, silver sulfide, copper sulfide, tin sulfide, tungsten sulfide, and antimony sulfide; metal selenides such as cadmium selenide, zirconium selenide, zinc selenide, titanium selenide, indium selenide, tungsten selenide, molybdenum selenide, bismuth selenide, and lead selenide; metal tellurides such as cadmium telluride, tungsten telluride, molybdenum telluride, zinc telluride, and bismuth telluride; metal phosphides such as zinc phosphide, gallium phosphide, indium phosphide, and cadmium phosphide; halides of metals, such as lithium fluoride, gallium arsenide, copper-indium-selenide, copper-indium-sulfide, silicon, germanium, and the like. The material may also be a mixture of two or more of these materials. Examples of the mixture include a mixture of zinc oxide and tin oxide, a mixture of tin oxide and titanium oxide, and the like.

The photoelectric conversion element of the present invention can generate a photovoltaic power between electrodes by irradiation with light such as solar light through transparent or translucent electrodes, and can operate as a thin film solar cell. By accumulating a plurality of thin film solar cells, the cells can be used as a thin film solar cell module.

A photocurrent can flow by irradiation with light through transparent or translucent electrodes while applying a voltage between the electrodes, and the photoelectric conversion element can operate as an organic light sensor. By accumulating a plurality of light sensors, the sensors can be used as an image sensor.

In the following, the present invention will be described in more detail by way of examples, but the present invention is not limited thereto.

### <Preparation Example 1> Preparation of composition 1

A conjugated polymer compound, poly(3-hexylthiophene) (P3HT) (5 parts by weight, manufactured by Merck & Co., Inc. under the trade name of lisicon SP001, lot. EF431002) as an electron-donating compound, 15 parts by weight of [6,6]-phenyl C61-butyric acid methyl ester (PCBM) (manufactured by Frontier Carbon, E100) as a fullerene derivative, and 1,000 parts by weight of o-dichlorobenzene as a solvent were mixed. After stirring at 70°C for 2 hours, the mixture was filtered through a Teflon® filter having a pore size of 1.0 µm to prepare a composition 1.

### <Example 1>

On a glass substrate having a 150 nm-thick ITO film formed by a sputtering method, which serves as a cathode, a dispersion liquid containing titanium dioxide particles and a dispersing agent dispersed therein (manufactured by Catalysts & Chemicals Industries Co., Ltd. under the trade name of titania sol HPW-10R), which serves as a functional layer, was applied by a spin coating method, followed by drying at room temperature to obtain a 70 nm-thick functional layer.

Application was conducted at room temperature under an atmospheric air at 4, 000 rpm for 60 seconds by a spin coating method. Drying was conducted by standing in an atmospheric air at room temperature for about 10 minutes. At this time, the electrical conductivity was 24 mS/cm.

The particle size of titanium dioxide in the dispersion liquid was from 8 to 13 nm, the electrical conductance of titanium dioxide was 24.6 mS/cm, the solvent in the dispersion liquid was water, and the pH of the dispersion liquid was 1.3. Then, the above composition 1 was applied to the functional layer by a spin coating method to form an active layer (thickness: about 100 nm) of the photoelectric conversion element. Then, an HIL691 solution (manufactured by Plextronics under the trade name of Plexcore HIL691) was applied to the active layer by a spin coating method to form an organic layer (thickness: about 50 nm). Then, Au was vapor-deposited in a thickness of 100 nm by a vacuum vapor deposition machine, which serves as an anode.

The shape of the organic thin film solar cell as the obtained photoelectric conversion element was a regular tetragon measuring 2 mm x 2 mm. The photoelectric conversion efficiency of the obtained organic thin film solar cell was determined by irradiating with constant light using Solar Simulator (manufactured by Bunkoukeiki Co., Ltd. under the trade name of CEP-2000, irradiance: 100 mW/cm²), and measuring the current and voltage generated. The photoelectric conversion efficiency was 1.5%.

### <Comparative Example 1>

On a glass substrate having a 150 nm-thick ITO film formed by a sputtering method, which serves as a cathode, a titanium oxide (TiOx) layer was formed by the method described in Advanced Materials, Vol. 18 (2006), pp. 572-576. That is, 10 mL of titanium (IV) isopropoxide (Ti[OCH(CH₃)₄], 50 mL of 2-methoxyethanol and 5 mL of ethanolamine were mixed in a three-necked flask under stirring at 80°C for 2 hours while flowing argon, followed by further mixing under stirring at 120°C for 1 hour to obtain a dispersion liquid containing TiOx. An oil bath was used for heating.

The dispersion liquid containing TiOx obtained by the above method was applied by a spin coating method and then dried at room temperature to obtain a 70 µm-thick titanium oxide layer. Then, the above composition 1 was applied to the titanium oxide layer by a spin coating method to obtain an active layer (thickness: about 100 nm) of the photoelectric conversion element. Then, an HIL691 solution (manufactured by Plextronics under the trade name of Plexcore HIL691) was applied to the active layer by a spin coating method to form an organic layer (thickness: about 50 nm). Then, Au was vapor-deposited in a thickness of 100 nm by a vacuum vapor deposition machine, which serves as an anode. The shape of the organic thin film solar cell as the obtained photoelectric conversion element was a regular tetragon measuring 2 mm x 2 mm. The photoelectric conversion efficiency of the obtained organic thin film solar cell was determined by irradiating with constant light using Solar Simulator (manufactured by Bunkoukeiki Co., Ltd. under the trade name of CEP-2000, irradiance: 100 mW/cm²), and measuring the current and voltage generated. The photoelectric conversion efficiency was 0.4%.

### -Evaluation-

As is apparent from the above, when a functional layer was formed by application of a dispersion liquid containing titanium dioxide particles, electricity was generated with higher photoelectric conversion efficiency than that in the case of using a TiOx layer.

### Industrial Applicability

Since the photoelectric conversion element of the present invention exhibits high photoelectric conversion efficiency, the present invention is extremely useful industrially.

## Claims

1. A photoelectric conversion element comprising an anode, a cathode, an active layer formed between the anode and the cathode, and a functional layer formed between the active layer and the cathode, wherein the functional layer is formed by application of a dispersion liquid containing titanium dioxide particles dispersed therein.

2. The photoelectric conversion element according to claim 1, wherein the titanium dioxide particles have a particle size of 10 µm or less.

3. The photoelectric conversion element according to claim 1 or 2, wherein the dispersion liquid has a pH of 1 to 7.

4. The photoelectric conversion element according to any one of claims 1 to 3, wherein the titanium dioxide particles have an electrical conductance of 0.01 mS/cm or more.

5. The photoelectric conversion element according to any one of claims 1 to 4, which includes an organic layer between the active layer and the anode.

6. The photoelectric conversion element according to claim 5, wherein the organic layer contains a polymer compound.

7. The photoelectric conversion element according to any one of claims 1 to 6, wherein one surface of the functional layer is in contact with the active layer and the other surface of the functional layer is in contact with the cathode.

8. The photoelectric conversion element according to any one of claims 1 to 7, wherein one surface of the organic layer is in contact with the active layer and the other surface of the organic layer is in contact with the anode.

9. The photoelectric conversion element according to any one of claims 1 to 8, wherein the active layer contains a fullerene derivative and a polymer compound.

10. A method for manufacturing a photoelectric conversion element, which comprises the steps of applying a dispersion liquid containing titanium dioxide particles dispersed therein to a cathode to form a functional layer; forming an active layer on the functional layer; and forming an anode on the active layer.
